# EUROPEAN PATENT SPECIFICATION

(11) **EP 2 109 205 B1**
(45) Date of publication and mention of the grant of the patent: **13.03.2013**
(21) Application number: 09004932.1
(22) Date of filing: 03.04.2009
(51) Int. Cl.: H02H 7/26, H02H 5/10, H02H 7/04, H02J 13/00

(54) **Remote operation control of a MV/LV transformer station and remote signalling of faults**
Fernbetriebssteuerung einer Mittelspannungs-/Niederspannungs-Transformatorstation und Fernsignalisierung von Fehlern
Commande de fonctionnement à distance de la station de transformateur moyenne-basse tension et signalisation à distance des erreurs

(30) Priority: 09.04.2008 SI 200800084
(43) Date of publication of application: 14.10.2009
(73) Proprietor: KOLEKTOR SINABIT d.o.o., 1235 Radomlje (SI); C & G d.o.o. Ljubljana, 1000 Ljubljana (SI)
(72) Inventor: Bezjak, Marjan, 2000 Maribor (SI); Toros, Zvonko, 5212 Dobrovo v Brdih (SI)
(74) Representative: Knoop, Philipp

(56) References cited:
- EP-A- 0 567 904
- WO-A-2008/117306
- SI-A- 22 276
- US-B1- 6 459 998

## Description

The subject of the invention is a device according to the preamble of claim 1, an MV/LV transformer station according to the preamble of claim 5, and a method for remote operation control of the MV/LV transformer station with the corresponding MV electric power line and for remote signalling of faults within them according to the preamble of claim 8, or more precisely a device and method for remote measuring of electrical quantities and for detecting faults in MV/LV transformer stations and for detecting interruptions of conductors on the basis of measured electrical quantities and element status changes in the observed transformer station, which includes forwarding information about faults and interruptions to the relevant control centre and, if required, to other addresses.

The technical problem solved by this invention is such a construction of a device to enable, in accordance with the corresponding method, a simple and effective remote measurement of electrical quantities and control of elements in a transformer station and within the MV electrical network and, furthermore, to enable remote signalling of measurement data in prescribed time intervals or in time intervals defined in advance, if changes are detected that indicate a fault, or also instant signalling, which will result in quick and reliable information concerning the type of fault in a transformer station and/or the interruption of one, two or of all three electrical conductors in an electrical power line, detected by the device at the selected location; at the same time, the construction of the device will be simple and compact, and it will be possible to build it in new or in already existing transformer stations.

There are several known devices for detecting interrupted conductors in electrical networks. According to patent S121482 A, a known device used to detect and to disconnect an interrupted semi-insulated conductor in MV power lines consists of an indicator unit at the end of semi-insulated conductors and of a disconnection unit at the beginning of semi-insulated conductors. It functions in such a way that the indicator unit detects the interruption of a semi-insulated conductor and transmits the information about that to the disconnection unit, which, via a suitable switch, disconnects the voltage in this interrupted line. Weakness and deficiency of this known solution is in the fact that it detects and signals only the presence or non-presence of phase voltage within a three-phase power line but it does not supply information concerning the number or interrupted conductors.

Another known solution is according to patent 5121717 A. According to this document, detecting the location of an interrupted conductor within all conductor types is selective, by means of adequately located detectors and by means of measuring interphase voltage, inverse and/or in-phase voltage system components. Weakness and deficiency of this known solution is that, in spite of a very demanding construction, it does not reveal the data about the number of interrupted conductors in this location.

A common feature of both previously described known solutions is in the fact that they make it possible to indicate interrupted conductors in the electrical network, but they do not reveal information about the number of interrupted conductors.

Furthermore, also known is the solution according to patent S122276 A. The device and method according to this document detect interrupted conductors and their number in a power line up to the location of the device but it does not detect and signal any other types of faults, e.g. faults in a transformer station or other faults in the electrical network and it does not enable remote measurement of electrical quantities in a transformer station.

EP 0 567 904 A1 discloses parameter monitoring equipment for an electrical power transformer center.

SI 22276 A discloses a device and method for indicating and signalling changes in a three-phase voltage system of power line, with the purpose to detect interrupted conductors.

Weaknesses and deficiencies of all previously described solutions represent a problem, which has remained unsolved.

According to the invention, the problem is solved by a device according to claim 1, by a MV/LV transformer station according to claim 3, and by a method according to claim 6. Preferred embodiments of the invention are given in the dependent claims.

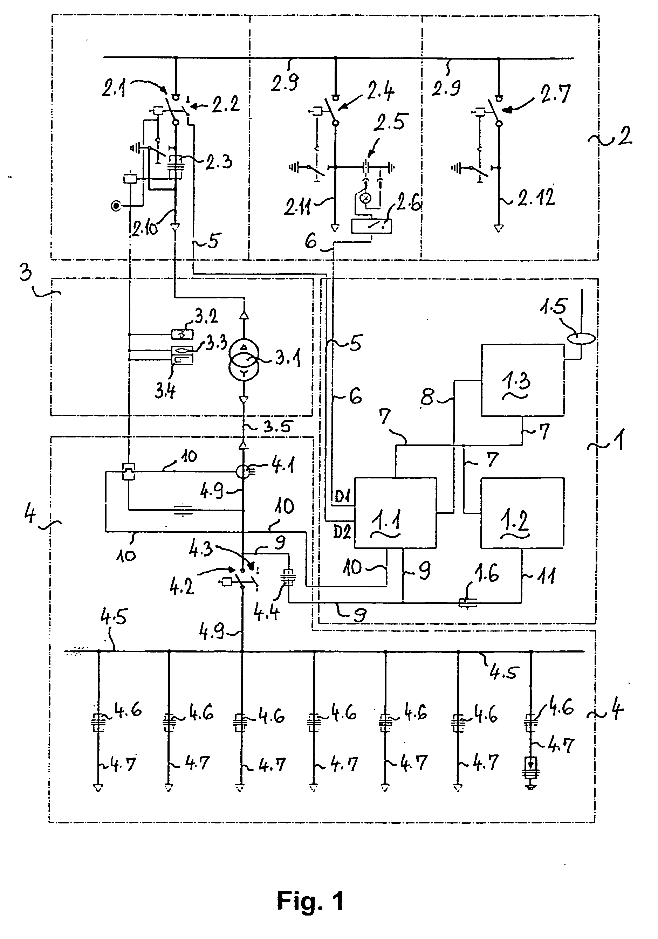

A device and method for remote operation control of the MV/LV transformer station with the corresponding MV electric power line and for remote signalling of faults within them, which is, together with the MV switchgear, transformer MV/LV unit and LV switch device, placed in the transformer station enables, together with the corresponding method, remote measurement and control of the operation of the MV/LV transformer station elements and, at the same time, it makes it possible to detect and signal faults and interruptions of electrical conductors of a power line and it, respectively, enables remote measurement of electrical quantities and remote collection of data about the status of transformer station elements and the status of conductors in the MV/LV electrical network according to the method, which is characterised by the fact that it detects, on the basis of measured parameters and changes of the status of transformer station elements, the type and location of faults within the transformer station and in conductors in the MV network; it transmits the information about faults acquired in this way to the relevant control centre in selected time intervals. The invention will be described on the basis of feasibility examples and figures, which present as follows:
- Fig. 1: single-pole scheme of the transformer station with a block scheme of the device according to the invention, first and preferential feasibility example
- Fig. 2: same as in Fig. 1, only without the possibility of indicating the presence of voltage, second feasibility example,
- Fig. 3: same as in Fig. 1, only without digital signal status of transformer switch, third feasibility example
- Fig. 4: same as in Fig. 1, only without the indication of the presence of voltage and without digital signal status of transformer switch, fourth feasibility example
- Fig. 5: block scheme of a measuring instrument
For all feasibility examples of the device for remote operation control of the MV/LV transformer station with the corresponding MV electric power line and for remote signalling of faults within them according to the invention, described below and presented in Figures 1, 2, 3, and 4, it applies the common feature that the remote measuring and control device 1 is built into the corresponding transformer station, together with the MV switchgear 2, transformer MV/LV unit 3 and LV switch device 4; the feasibility examples differ only in the constructions of the elements of the MV switchgear 2 and in its connections to the remote measuring and control device 1, respectively, which, however, has the same construction in all examples. Thereby MV stands for medium voltage, whereas LV indicates low voltage.

In relation to this, it also applies to all feasibility examples that the remote measuring and control device 1, which is capable of remote measuring of electric quantities in the MV/LV transformer station, is intended for operation control of individual transformer station elements and, simultaneously, for detecting and signalling faults and for signalling interruptions of electric conductors; it is built of a measuring instrument 1.1, rectifier 1.2 with a battery, which is not shown, and communication device 1.3. Thereby the measuring instrument 1.1 functions as analyzer and the rectifier 1.2 has a built-in battery as an auxiliary-voltage source for the remote measuring and control device 1.

The measuring instrument 1.1 is connected, via communication line 8, to the communication device 1.3, both of them are supplied with auxiliary voltage from the rectifier 1.2 with a battery, via line 7. Thereby the communication line 8 preferentially represents an RS 232/485 or Ethernet connection. The communication device 1.3 is equipped with an appropriate antenna 1.5.

In Fig. 1, it is shown for the first and preferential feasibility example of the device according to the invention that the remote measuring and control device 1 with the measuring instrument 1.1 is, through LV fuses 4.4 with line 9 (three-phase LV) with insulated conductors, connected to a three-phase LV supply line 4.9 of switch device 4, and, via line 10 with insulated conductors, to three LV current instrument transformers 4.1 of the LV switch device 4. Additionally, the rectifier 1.2 with a battery is connected to line 9 of the three-phase LV supply line 4.9, via one-phase line 11 and through LV fuse 1.6.

Besides, the MV switchgear 2 is connected to the measuring instrument 1.1 of the remote measuring and control device 1, via digital line 5, by means of the contact 2.2 of a separating switch 2.1 and, additionally, by means of digital line 6 with the indicator 2.6 of the capacitive voltage divider 2.5. Thereby the contact 2.2 indicates the position on/off of the separating switch 2.1, whereas the indicator 2.6 shows presence/non-presence in the MV supply line 2.11.

The MV supply line 2.11 is, via separating supply switch 2.4, connected to the MV busbars 2.9, to which, via separating switch 2.1, the MV discharge line 2.10 is connected and leading to the transformer MULV unit 3. The MV discharge line 2.10 leads to the transformer MV/LV unit 3. The MV discharge line 2.12 leads from the separating discharge switch 2.7, which is also connected to the MV busbars 2.9, to the next transformer station.

At the low voltage side, the energy transformer 3.1 is, via LV discharge line 3.5, connected to the three-phase LV supply line 4.9 with the LV current instrument transformer 4.1 within the LV switch device 4 and, additionally, it is connected, via three-phase LV supply line 4.9 and, via LV switch 4.2, to the LV busbars 4.5. From the busbars 4.5, via LV fuses 4.6 or another appropriate protective element, LV outlets 4.7 are constructed, leading to electricity consumers.

Furthermore, in addition to the already mentioned energy transformer 3.1, the transformer MV/LV unit 3 consists of a contact thermometer 3.2, switch-off contact 3.3 and warning contact 3.4 of a Buchholz relay.

Within one transformer station, one or more remote measuring and control devices 1 according to this invention can be placed, depending on the number of included transformer MV/LV units 3 within one transformer station with at least one communication device 1.3.

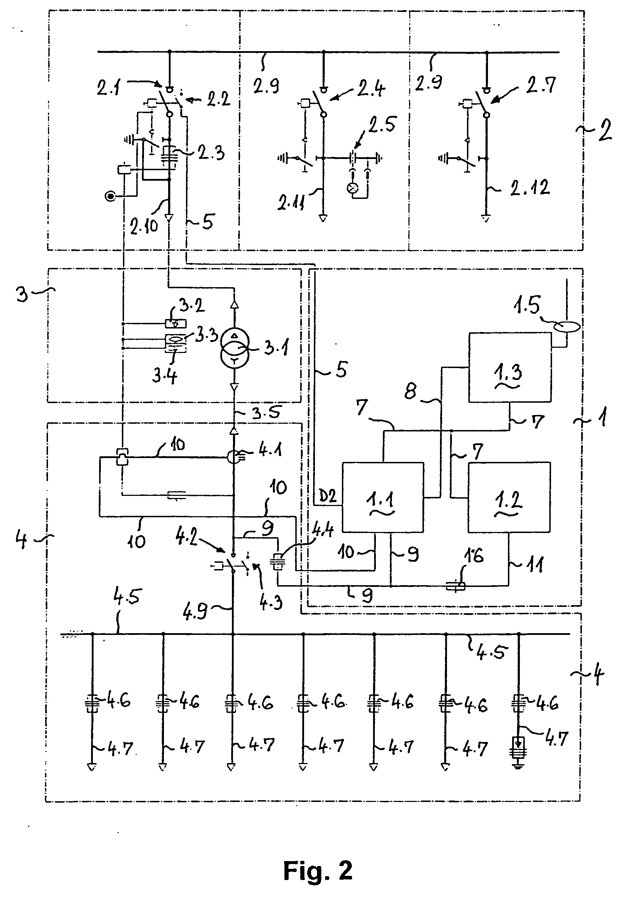

In Fig. 2, the second feasibility example of a remote measuring and control device 1 is shown, which differs from the previously described first feasibility example from Fig. 1 as it does not enable the indication of the presence/non-presence of voltage in the MV supply line 2.11 as no indicator 2.6 is built into it, whereas, in the first feasibility example, the indicator 2.6 is, via digital line 6, connected to the measuring instrument 1.1. Consequently, also in the second feasibility example, the remote measuring and control device 1 consists of a measuring instrument 1.1, rectifier 1.2 with a battery, which is not shown, as an auxiliary-voltage source, and of the communication device 1.3; similarly, the measuring instrument 1.1 is, via communication line 8, connected to the communication device 1.3, and both of them get supply from the rectifier 1.2 with a battery, via line 7. In the second feasibility example, the remote measuring and control device 1 is connected to the MV switchgear 2 solely via digital line 5, which also leads from the measuring instrument 1.1 to the contact 2.2 of the MV switchgear 2 indicating the position on/off of the separating switch 2.1. The MV supply line 2.11 is, via separating supply switch 2.4, connected to the MV busbars 2.9, from which the MV discharge line 2.12 leads, via separating discharge switch 2.7, to the next transformer station in the row. Furthermore, from MV busbars 2.9, via separating switch 2.1 and via MV fuses 2.3, the MV discharge line 2.10 leads, which connects the MV switchgear 2 to the energy transformer 3.1 in the transformer MV/LV unit 3. Similarly as in the first feasibility example, in the second feasibility example, the energy transformer 3.1 at the low voltage side is connected, via LV discharge line 3.5, to the three-phase LV supply line 4.9 in the LV switch device 4 and, further, via LV switch 4.2, to the LV busbars 4.5. From LV busbars 4.5, LV outlets 4.7 are constructed, via LV fuses 4.6 or another appropriate protective element, leading to electricity consumers.

Also in this example, the remote measuring and control device 1 with the measuring instrument 1.1 is, via line 9, connected to the three-phase LV supply line 4.9, and, via line 10, to the three LV current instrument transformers 4.1.

It applies also for the second feasibility example that one or more remote measuring and control devices 1 according to this invention can be placed in one transformer station, depending on the number of the transformer MV/LV units 3 within one transformer station.

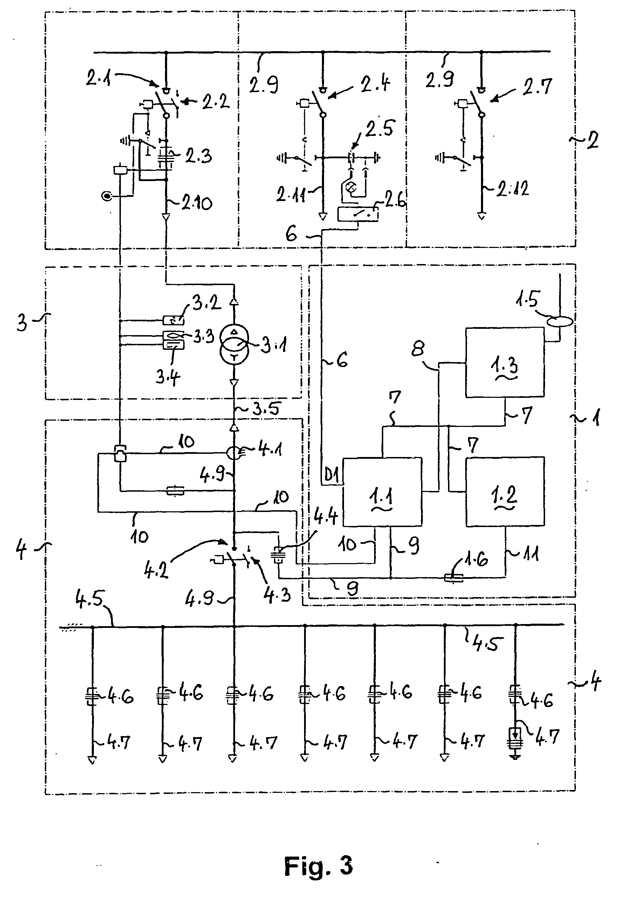

Fig. 3 shows the third feasibility example of a remote measuring and control device 1, which differs from the previously described first feasibility example from Fig. 1 as it does not enable the occurrence of a digital signal indicating the position on/off of the separating switch 2.1, by means of the contact 2.2 in the MV switchgear 2 because the separating switch 2.1 is not connected, via contact 2.2, to the measuring instrument 1.1 in the remote measuring and control device 1, which is done, by means of a digital line 5, in the first feasibility example from Fig. 1 and also in the second feasibility example from Fig. 2, respectively. In this feasibility example, however, the indicator 2.6 is, via digital line 6, connected to the measuring instrument 1.1.

It applies for the third feasibility example that its construction is identical to the construction of the first, preferential example from Fig. 1, with the exception of the previously mentioned absence of the digital line 5 between the measuring instrument 1.1 and contact 2.2, therefore this part of description is not repeated.

It applies also for the third feasibility example of the remote measuring and control device 1 according to the invention that one or more such devices can be placed in one transformer station, depending on the number of transformer MV/LV units 3 within one transformer station.

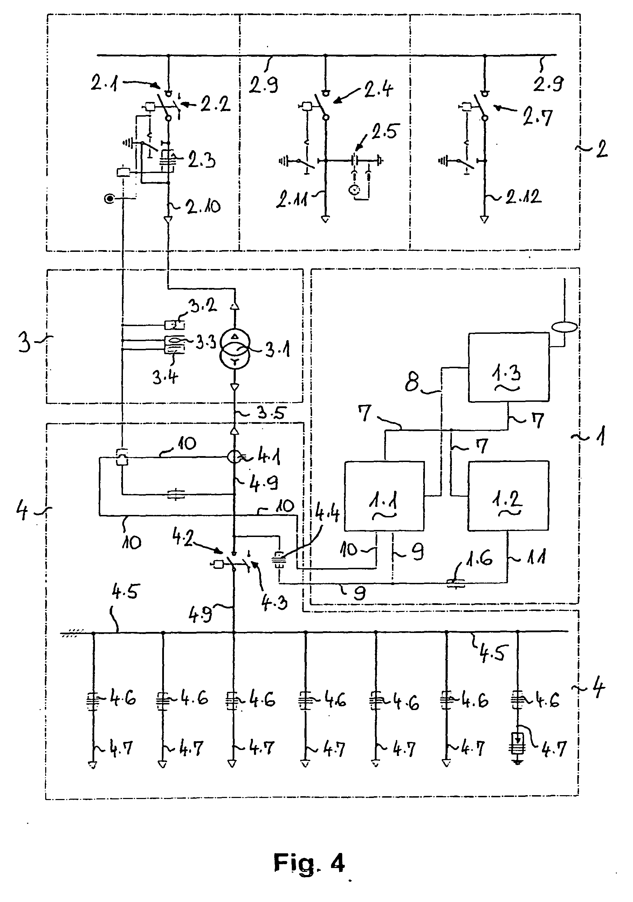

Fig. 4 shows the fourth feasibility example of the remote measuring and control device 1, which differs from the previously described first feasibility example from Fig. 1 as it does not enable the occurrence of a digital signal indicating the position on/off of the separating switch 2.1, via contact 2.2 in the MV switchgear 2 and it also does not enable the indication of presence/non-presence of voltage in the MV supply line 2.11 because the measuring instrument 1.1 in the remote measuring and control device 1 is not connected to the contact 2.2 of the separating switch 2.1 and also not to the MV supply line 2.11, whereas, in the first feasibility example from Fig. 1, the connection is performed by means of digital lines 5 and 6. In the fourth feasibility example, the indicator 2.6 is not built into the MV switchgear 2.

It applies for the fourth feasibility example that its construction is identical to the construction of the first, preferential feasibility example from Fig. 1, with the exception of the previously mentioned absence of the digital line 5 between the measuring instrument 1.1 and contact 2.2 and of the digital line 6 between the measuring instrument 1.1 and the MV supply line 2.11, and the absence of the indicator 2.6 in the MV switchgear 2, therefore this part of the description is not repeated.

Similarly as for all the previously mentioned examples, it applies also for the fourth feasibility example of the remote measuring and control device 1 according to the invention that one or more devices can be placed in one transformer station, depending on the number of transformer MV/LV units 3 within one transformer station.

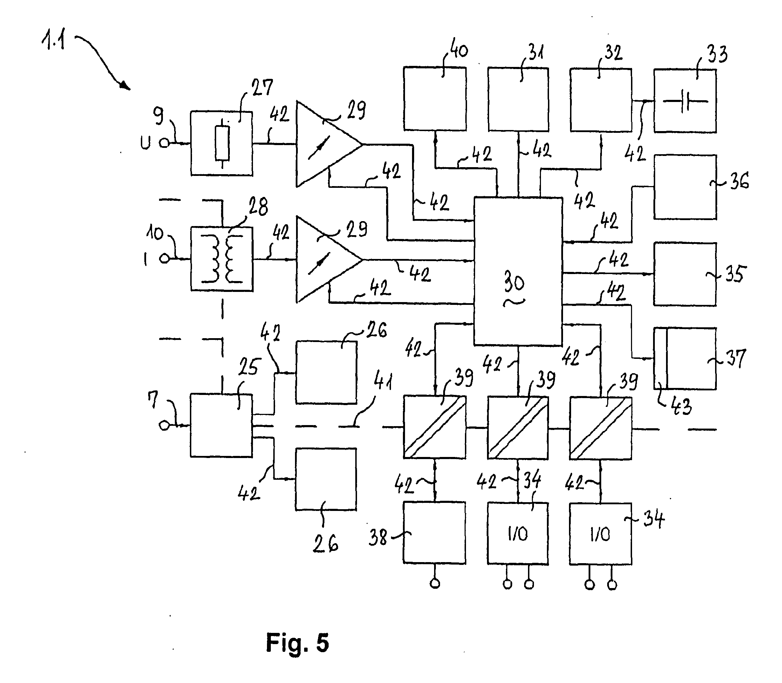

Fig. 5 shows the construction of the measuring instrument 1.1, which is placed inside the remote measuring and control device 1 according to the invention and therein, it is, via line 7, connected to the rectifier 1.2 with a battery, and, via communication line 8, to the communication device 1.3, whereas it is, via line 9, connected to the three-phase LV supply line 4.9, and, via line 10, to the LV current instrument transformer 4.1, both within the LV switch device 4, which is evident from all feasibility examples presented in Fig. 1 to 4 included.

The microprocessor 30 is the central element of the measuring instrument 1.1 and all other component parts are, via connections 42, connected to it. Thus, the resistor divider 27 and programmable amplifier 29 are connected to it, on the other side they are connected to line 9. Furthermore, current measuring transformer 28 and programmable amplifier 29, which are on the other side connected to line 10, are connected to it. In addition to them, the galvanic disconnection 25, which is on the other side connected to line 7, with auxiliary supply 26 and with intermediate optocouplers 39 is connected to it, whereas the communications module 38, via communication line 8, and at least two digital entrances/exits 34, via digital lines 5 and 6, are connected to optocouplers 39. Furthermore, Data Flash storage 40, EEPROM storage 31, RTC real-time clock 32 with battery 33, LCD display 35, keyboard 36 and MMC card 37 are connected to the microprocessor 30.

Electrical voltage, measured with the measuring instrument 1.1, is led, via line 9, from the corresponding three-phase LV supply lines 4.9 of the LV switch device 4 to resistor dividers 27 at the entrance to the measuring instrument 1.1. The electrical currents that are measured are led, via line 10, from the LV current instrument transformer 4.1 in the LV switch device 4 to the current measuring transformer 28 at the entrance to the measuring instrument 1.1. The quantities of electrical current and voltage are supplied, via programmable amplifier 29 and via connection 42, to the microprocessor 30. Thereby it applies that one programmable amplifier 29 is required for each measured quantity.

The microprocessor 30 calculates the values of input electrical quantities and, simultaneously, on the basis of these values, it calculates also other electrical quantities. Data Flash storage 40, EEPROM storage 31, module or RTC real-time clock 32 with time relay to set delayed alarms with battery 33, keyboard 36, LCD display 35 and MMC memory card 37, which can be inserted via connector 43, used for data transfer, for settings and upgrades, are connected to the microprocessor 30, via printed circuit and connections 42, respectively. The values calculated in this way and alarm settings defined in advance are stored in the EEPROM storage 31 and Data Flash storage 40.

Furthermore, digital entrances/exits 34 and communications module 38 for entrance/exit, which is, via communication line 8 - preferentially RS 232/485 or Ethernet connection, connected to the communication device 1.3, are connected to the microprocessor 30, via optocouplers 39.

The auxiliary supply voltage is supplied to the measuring instrument 1.1 by means of lines 7, i.e. to the module and galvanic disconnection 25, respectively, and from there onwards, the supply voltage is divided, by means of galvanic disconnection 41, between circuits - to the internal and external auxiliary supply 26; the circuits are connected via galvanically separated printed circuits and connections 42, respectively.

It applies for the remote measuring and control device 1 according to the invention that current quantities of electrical current and electrical voltage are measured, on the basis of which all electrical quantities are calculated in the measuring instrument 1.1, including effective values of phase voltages, values of interphase voltages and line currents, activity factor, time angles between phase voltages, active power, reactive power, active energy, reactive energy, etc. The measured and calculated values are stored in the Data Flash storage 40 and EEPROM storage 31, selected values also in the MMC memory card 37 and are, in certain time intervals and via communications module 38, transferred to the communication device 1.3. To digital entrances and connections 42, respectively, of the measuring instrument 1.1, D1 status signals from the contact 2.2 and D2 signals from the indicator 2.6 are transferred, which are led, via microprocessor 30 and via communications module 38, to the communication device 1.3.

In case of different faults, the measured electrical quantities and/or status signals from the observed transformer station elements are changed accordingly. On the basis of the combination of data received from the measuring instrument 1.1, the communication device 1.3 defines the type and location of the fault and generates an appropriate message, which it sends immediately, with previously defined delay, to the qualified superior and to the relevant centre, respectively, if required, also to other addresses. In some other feasibility example, the communication device 1.3 can only receive the previously mentioned data combinations and sends the data immediately, considering the previously defined delay, to the relevant centre, where the type and location of the fault are defined, and operator's logical messages are generated. This option is not specially mentioned in the last column in table 1 to 4 that follow.

According to the algorithm for the operation of the remote measuring and control device 1 according to the invention, the signalling of faults is based on the indication of changes of LV effective values of interphase voltage U₂ and time angle α between fundamental harmonic functions of phase voltages and status signal D1 from the indicator 2.6, which indicates the presence or non-presence of voltages and status signal D2 from the contact 2.2, which indicates the position of the separating switch 2.1 for the first, preferential feasibility example from Fig. 1, for which the effects are presented in table 1:

**Table 1**

| **Algorithm of the operation of the system with two signals: D₁ and D₂** | | | | |
|---|---|---|---|---|
| Measuring instrument 1.1 | Measuring instrument 1.1 All angles α > 15° | D₁ Presence of MV voltage | D₂ MV switch on | Communication device 1.3 Message |
| All U₂ > 0,7·U_{2N} | YES | YES | YES | Status OK |
| All U₂ > 0,7·U_{2N} | NO | YES | YES | 1 conductor broken |
| One U₂ < 0,7·U_{2N} | - | YES | YES | 1 conductor broken |
| All U₂ < 0,7·U_{2N} | - | YES | YES | 2 conductors broken |
| All U₂ < 0,7·U_{2N} | - | NO | YES | 3 conductors broken |
| All U₂ < 0,7·U_{2N} | - | YES | NO | TS fault |

| | | | | |
|---|---|---|---|---|
| U₂ - LV effective value of interphase voltage measured by the measuring instrument 1.1 U_{2N} - known LV nominal effective value of interphase voltage α - time angle between fundamental harmonic functions of phase voltages measured by measuring instrument 1.1 D₁ - digital status signal of presence or non-presence of MV voltage detected by indicator 2.6 D₂ - digital status signal indicating the position on/off of the transformer switch from the contact 2.2 | | | | |

Furthermore, in relation to the algorithm of the operation of the remote measuring and control device 1 according to the invention, signalling of faults is based on the indication of changes of LV effective values of interphase voltages U₂ and time angle α between fundamental harmonic functions of phase voltages and status signal D1 from the contact 2.2, which indicates the position of the separating switch 2.1 for the second feasibility example from Fig. 2, the effects of which are presented in table 2:

**Table 2**

| **Algorithm of the operation of the system with digital signal D₂** | | | | |
|---|---|---|---|---|
| Measuring instrument 1.1 | Measuring instrument 1.1 All angles α > 15° | | D₂ MV switch on | Communication device 1.3 Message |
| All U₂ > 0,7·U_{2N} | YES | | YES | Status OK |
| All U₂ > 0,7·U_{2N} | NO | | YES | 1 conductor broken |
| One U₂ < 0,7·U_{2N} | - | | YES | 1 conductor broken |
| All U₂ < 0,7·U_{2N} | - | | YES | 2 or 3 conductors broken |
| All U₂ < 0,7·U_{2N} | - | | NO | TS fault |

| | | | | |
|---|---|---|---|---|
| U₂ - LV effective value of interphase voltage measured by measuring instrument 1.1 U_{2N} - known LV nominal effective value of interphase voltage α - time angle between fundamental harmonic functions of phase voltages measured by measuring instrument 1.1 D₂ - digital status signal indicating the position on/off of the transformer switch from the contact 2.2 | | | | |

Furthermore, in relation to the algorithm of the operation of the remote measuring and control device 1 according to the invention, signalling of faults is based on the indication of changes of LV effective values of interphase voltages U₂ and time angle α between fundamental harmonic functions of phase voltages and D1 status signal from the indicator 2.6, which indicates the presence or non-presence of LV effective interphase voltage U₂ for the third feasibility example from Fig. 3, the effects of which are presented in table 3:

**Table 3**

| **Algorithm of the operation of the system with digital signal D₁** | | | | |
|---|---|---|---|---|
| Measuring instrument 1.1 | Measuring instrument 1.1 All angles α > 15° | D₁ Presence of MV voltage | | Communication device 1.3 Message |
| All U₂ > 0,7·U_{2N} | YES | YES | | Status OK |
| All U₂ > 0,7·U_{2N} | NO | YES | | 1 conductor broken |
| One U₂ < 0,7·U_{2N} | - | YES | | 1 conductor broken |
| All U₂ < 0,7·U_{2N} | - | YES | | 2 conductors broken or fault in TS |
| All U₂ < 0,7·U_{2N} | - | NO | | 3 conductors broken |

| | | | | |
|---|---|---|---|---|
| U₂ - LV effective value of I interphase voltage measured by the measuring instrument 1. U_{2N} - known LV nominal effective value of interphase voltage α - time angle between fundamental harmonic functions of phase voltages measured by measuring instrument 1.1 D₁ - digital status signal of presence or non-presence of MV voltage detected by indicator 2.6 | | | | |

Furthermore, in relation to the algorithm of the operation of the remote measuring and control device 1 according to the invention, signalling of faults is based on the indication of changes of LV effective values of interphase voltages U₂ and time angle α between fundamental harmonic functions of phase voltages for the fourth feasibility example from Fig. 4, the effects of which are presented in table 4:

**Table 4**

| **Algorithm of the operation of the system without signals D₁ and D₂** | | | | |
|---|---|---|---|---|
| Measuring instrument 1.1 | Measuring instrument 1.1 All angles α > 15° | | | Communication device 1.3 Message |
| All U₂ > 0,7·U_{2N} | DA | | | Status OK |
| All U₂ > 0,7·U_{2N} | NE | | | 1 conductor broken |
| One U₂ < 0,7·U_{2N} | - | | | 1 conductor broken |
| All U₂ < 0,7·U_{2N} | - | | | 2 or 3 conductors broken or fault in TS |

| | | | | |
|---|---|---|---|---|
| U₂ - LV effective value of interphase voltage measured by measuring instrument 1.1 U_{2N} - known LV nominal effective value of interphase voltages α - time angle between fundamental harmonic functions of phase voltage measured by measuring instrument 1.1 | | | | |

## Claims

1. Remote measuring and control device (1) for remote operation control of an MV/LV transformer station with a corresponding MV electric power line (2.9) and for remote signalling of faults within them, the MV/LV transformer station having an MV switchgear (2), a transformer MV/LV unit (3) and an LV switch device (4) **characterised in that**, the remote measuring and control device (1) is adapted to be built-in in the corresponding or observed transformer station, and that the remote measuring and control device (1) consists of at least one measuring instrument (1.1), which is connected, via a communication line (8), to at least one communication device (1.3), and of at least one rectifier (1.2) with a built-in battery, the rectifier (1.2) being connected, via a line 7, to the measuring instrument (1.1) and to the communication device (1.3); whereby the remote measuring and control device (1) is, via the measuring instrument (1.1), connectable to the LV switch device (4) so that it is, via a line (9) and trough an LV fuse (4.4), connectable to a three-phase LV supply line (4.9) of the LV switch device (4) and, via a line (10), to an LV current instrument transformer (4.1) of the LV switch device (4), wherein
at a first status signal (D2), the measuring instrument (1.1) is, via a first digital line (5), connectable to a contact (2.2) _of a separating switch (2.1) of the MV switchgear (2), and, by means of said contact (2.2), is connectable to the transformer MV/LV unit (3), and wherein
at a second status signal (D1), the measuring instrument (1.1) is, via a second digital line (6), connectable to an indicator (2.6), for indicating presence/non-presence of voltage in an MV supply line of a capacitive voltage divider (2.5) of the MV switchgear (2),
wherein the measuring instrument (1.1) has a microprocessor (30), and the communication device (1.3) comprises means for identifying, on the basis of data combination of the corresponding measuring instrument (1.1) and at the presence of the first status signal (D2) and/or the second status signals (D1), the type and location of fault for generating information, and for immediately sending, once it detects the fault, the information and for immediately sending, once it detects the fault, the relevant centre and, if required, to other addresses, within a set time delay, wherein the type and location of fault are identifiable and the fault is detectable the basis of changes of LV effective values of interphase voltages U₂ and time angle α between fundamental harmonic functions of phase voltages, wherein the type and location of fault are identifiable and the fault is detectable furthermore on the basis of the position on/off of the separating switch (2.1) of the MV switchgear (2), and wherein the type and location of fault are identifiable and the fault is detectable furthermore on the basis of presence/non-presence of voltage in an MV supply line (2.11) of the capacitive voltage divider (2.5) of the MV switchgear (2).

2. The device according to claims 1, **characterised in that** the number of measuring instruments (1.1) is selected depending on the number of transformer MV/LV units (3) within the transformer station.

3. MV/LV transformer station having an MV switchgear (2), a transformer MV/LV unit (3) and an LV switch device (4), **characterised in that** it further comprises at least one remote measuring and control device (1) according to one of claim 1 to 2, the remote measuring and control device (1) being connected to the LV switch device (4) so that the remote measuring and control device (1) is, via the line (9) and through an LV fuse (4.4), connected to a three-phase LV supply line (4.9) of the LV switch device (4) and, via the line (10), to an LV current instrument transformer (4.1) of the LV switch device (4)

4. MV/LV transformer station according to claim 3, **characterized in that** the MV switchgear (2) is provided with a contact (2.2), for indicating the position on/off of a separating switch (2.1) thereof.

5. MV/LV transformer station according to claim 3 or 4, **characterized in that** the MV switchgear (2) is provided with an indicator (2.6), for indicating presence/non-presence of voltage in an MV supply line of a capacitive voltage divider (2.5) thereof.

6. Method for remote operation control of an MV/LV transformer station with a corresponding MV electric power line (2.9) and for remote signalling of faults within them, **characterised in that**, it employs a remote measuring and control device (1) in accordance with claims 1, and the communication device (1.3), on the basis of data combination of the corresponding measuring instrument (1.1) and at the presence of the first status signal (D2) and/or the second status signals (D1), identifies the type and location of fault generates information, and once it detects the fault, it immediately sends the information to the relevant centre and, if required, to other addresses, within a set time delay, wherein the type and location of fault are identified and the fault is detected on the basis of changes of LV effective values of interphase voltages U₂ and time angle a between fundamental harmonic functions of phase voltages, wherein the type and location of fault are identified and the fault is detected furthermore on the basis of the position on/off of the separating switch (2.1) of the MV switchgear (2), and wherein the type and location of fault are identified and the fault is detected furthermore on the basis of presence/non-presence of voltage in the MV suppl line (2.11) of the capacitive voltage divider (2.5) of the MV switchgear (2).

7. Method according to Claim 6, **characterised in that** a fault of one broken conductor within an electrical MV line is signalled if all LV effective values of interphase voltage are U₂ > 0,7. U_{2N} and the time angle is α < 15°, and at the same time, the separating switch (2.1) is on and the voltage in the MV supply Line (2.11) of the capacitive voltage divider (2.5) of the MV switchgear (2) is also present.

8. The method according to Claim 6 **characterised by** the fact that a fault of one broken conductor within the electrical MV line is signaled if one LV effective value of interphase voltage is U₂ < 0,7 . U_{2N}, and at the same time, the separating switch (2.1) is on and the voltage in the MV supply Line (2.11) of the capacitive voltage divider (2.5) of the MV switchgear (2) is also present.

9. The method according to Claim 6 **characterised by** the fact that the remote measuring and control device (1) signals the fault of two broken conductors within the electrical MV line if all LV effective values of interphase voltages are U₂ < 0,7 . U_{2N}, and at the same time, the separating switch (2.1) is on and the voltage in the MV supply Line (2.11) of the capacitive voltage divider (2.5) of the MV switchgear (2) s present.

10. The method according to Claim 6 **characterised by** the fact that the remote measuring and control device (1) signals the fault of three broken conductors within the electrical MV line if all LV effective values of interphase voltages are U₂ < 0,7 . U_{2N}, and if, at the same time, the separating switch (2.1) is on and the voltage in the MV supply Line (2.11) of the capacitive voltage divider (2.5) of the MV switchgear (2) is absent.

11. The method according to Claim 6 **characterised by** the fact that the remote measuring and control device (1) signals the fault of the transformer station if all LV effective values of interphase voltages are U₂ < 0,7 . U_{2N}, and if, at the same time, the voltage in the MV supply Line (2.11) of the capacitive voltage divider (2.5) of the MV switchgear (2) is present-and the separating switch (2.1) is off.

## Patentansprüche

1. Fernmess- und -steuervorrichtung (1) zur Fernbedienung einer MS/NS-Transformatorstation mit einer entsprechenden MS-Elektrizitätsleitung (2.9) und zur Fernmeldung von Störungen darin, wobei die MS/NS-Transformatorstation eine MS-Schalteinrichtung (2), eine Transformator-MS/ NS-Einheit (3) und eine NS-Umschalteinrichtung (4) hat, **dadurch gekennzeichnet, dass** die Fernmess- und -steuereinrichtung (1) zum Einbau in die entsprechende oder überwachte Transformatorstation angepasst ist und dass die Fernmess- und -steuereinrichtung (1) aus wenigstens einem Messgerät (1.1), das über eine Kommunikationsleitung (8) mit wenigstens einem Kommunikationsgerät (1.3) verbunden ist, und wenigstens einem Gleichrichter (1.2) mit einer eingebauten Batterie besteht, wobei der Gleichrichter (1.2) über eine Leitung (7) mit dem Messgerät (1.1) und dem Kommunikationsgerät (1.3) verbunden ist; wobei die Fernmess- und -steuereinrichtung (1) über das Messgerät (1.1) mit der NS-Umschalteinrichtung (4) verbindbar ist, so dass es über eine Leitung (9) und über eine NS-Sicherung (4.4) mit einer Dreiphasen-NS-Versorgungsleitung (4.9) der NS-Umschalteinrichtung (4) und über eine Leitung (10) mit einem NS-Stromwandler (4.1) der NS-Umschalteinrichtung verbindbar ist, wobei bei einem ersten Zustandssignal (D2) das Messgerät (1.1) über eine erste Digitalleitung (5) mit einem Kontakt (2.2) eines Trennschalters (2.1) der MS-Schalteinrichtung (3) verbindbar ist, und durch Mittel des Kontakts (2.2) mit der Transformator-MS/ NS-Einheit (3) verbindbar ist, und wobei bei einem zweiten Zustandssignal (D1) das Messgerät (1.1) über eine zweite Digitalleitung (6) mit einem Anzeigegerät (2.6) zum Anzeigen des Vorhandensein/ Nicht-Vorhandensein von Spannung in einer MS-Zufuhrleitung eines kapazitiven Spannungsteiler (2.5) der MS-Schalteinrichtung (2) verbindbar ist, wobei das Messgerät (1.1) einen Mikroprozessor (30) hat, und das Kommunikationsgerät (1.3) Mittel zum Identifizieren auf der Basis von Datenkombinationen des entsprechenden Messgeräts (1.1) und bei Anwesenheit des ersten Zustandssignals (D2) und/oder des zweiten Zustandssignal (D1) Bestimmen der Art und des Ortes der Störung umfasst, zum Erzeugen einer Information und, sobald die Störung entdeckt wurde, zum sofortigen Senden zu dem maßgebliche Zentrum und, wenn erforderlich, zu anderen Adressen, innerhalb einer eingestellten Verzögerungszeit, wobei die Art und der Ort der Störung bestimmbar sind und die Störung ermittelbar ist auf der Basis von Veränderungen der NS-Effektivwerte der Ausgleichsspannung U₂ und Zeitwinkel α zwischen grundlegenden harmonischen Funktionen der Phasenspannungen, wobei die Art und der Ort der Störung bestimmbar sind und die Störung weiterhin ermittelbar ist auf der Basis der Position an/aus des Trennschalters (2.1) der MS-Schalteinrichtung (2), und wobei die Art und der Ort der Störung bestimmbar sind und die Störung weiterhin ermittelbar ist auf der Basis der Position des Vorhandensein/Nicht-Vorhandenseins der Spannung in einer MS-Zufuhrleitung (2.11) des kapazitiven Spannungsteilers (2.5) der MS-Schalteinrichtung (2).

2. Vorrichtung gemäß Anspruch 1, **dadurch gekennzeichnet, dass** die Anzahl der Messgeräte (1.1) abhängig von der Anzahl der Transformator-MS/ NS-Einheiten (3) innerhalb der Transformatorstation ausgewählt ist.

3. MS/NS-Transformatorstation mit einer MS-Schalteinrichtung (2), einer Transformator-MS/NS-Einheit (3) und einer NS-Umschalteinrichtung (4), **dadurch gekennzeichnet, dass** sie weiterhin wenigstens eine Fernmess- und -steuervorrichtung (1) gemäß einem der Ansprüche 1 bis 2 umfasst, wobei die Fernmess- und -steuervorrichtung (1) mit der NS-Umschalteinrichtung (4) verbunden ist, so dass die Fernmess- und -steuervorrichtung (1) über eine Leitung (9) und über eine NS-Sicherung (4.4) mit einer Dreiphasen-NS-Versorgungsleitung (4.9) der NS-Umschalteinrichtung (4) und über eine Leitung (10) mit einem NS-Stromwandler (4.1) der NS-Umschalteinrichtung (4) verbunden ist.

4. MS/NS-Transformatorstation gemäß Anspruch 3, **dadurch gekennzeichnet, dass** die MS-Schalteinrichtung (2) einen Kontakt (2.2) zum Anzeigen der Position an/ aus eines Trennschalters (2.1) davon aufweist.

5. MS/NS-Transformatorstation gemäß Anspruch 3 oder 4, **dadurch gekennzeichnet, dass** die MS-Schalteinrichtung (2) ein Anzeigegerät (2.6) aufweist, zum Anzeigen des Vorhandensein/Nicht-Vorhandensein der Spannung in einer MS-Zufuhrleitung eines kapazitiven Spannungsteiler (2.5) davon.

6. Verfahren zur Fernbedienung einer MS/NS-Transformatorstation mit einer entsprechenden MS-Elektrizitätsleitung (2.9) und für die Fernmeldung von Störungen darin, **dadurch gekennzeichnet, dass** es eine Fernmess- und -steuervorrichtung (1) gemäß den Ansprüchen 1 und 6 einsetzt und das Kommunikationsgerät (1.3) auf der Basis von Datenkombinationen des entsprechenden Messgeräts (1.1) und bei Vorhandensein des ersten Zustandssignals (D2) und/oder dem zweiten Zustandssignal (D1) die Art und den Ort der Störung bestimmt, Informationen erzeugt, sobald es die Störung entdeckt, die Information unmittelbar zu dem maßgeblichen Zentrum sendet, und, wenn erforderlich, zu anderen Adressen, innerhalb einer eingestellten Verzögerungszeit, wobei die Art und der Ort der Störung bestimmt werden und wobei die Störung auf der Basis von Veränderungen der NS-Effektivwerte der Ausgleichsspannung U₂ und Zeitwinkel α zwischen grundlegenden harmonischen Funktionen der Phasenspannungen ermittelt wird, wobei die Art und der Ort der Störung bestimmt werden und die Störung weiterhin ermittelt wird auf der Basis der Stellung An/Aus des Trennschalters (2.1) der MS-Schalteinrichtung (2), und wobei die Art und der Ort der Störung bestimmt werden und die Störung weiterhin ermittelt wird auf der Basis des Vorhandensein/NichtVorhandenseins der Spannung in der MS-Zufuhrleitung (2.11) des kapazitiven Spannungsteilers (2.5) der MS-Schalteinrichtung (2).

7. Verfahren gemäß Anspruch 6, **dadurch gekennzeichnet, dass** eine Störung einer unterbrochenen Leitung innerhalb einer elektrischen MS-Leitung angezeigt wird, wenn alle NS-Effektivwerte der Ausgleichsspannung U₂ >0,7 . U₂ sind und der Zeitwinkel α < 15° ist, und zur gleichen Zeit der Trennschalter (2.1) an ist und die Spannung in der MS-Zufuhrleitung (2.11) des kapazitiven Spannungsteilers (2.5) der MS-Schalteinrichtung (2) vorhanden ist.

8. Verfahren gemäß Anspruch 6, **gekennzeichnet durch** die Tatsache, dass eine Störung einer unterbrochenen Leitung innerhalb einer elektrischen MS-Leitung angezeigt wird, wenn ein NS-Effektivwerte der Ausgleichsspannung U₂ >0,7 . U₂ ist und zur gleichen Zeit der Trennschalter (2.1) an ist und die Spannung in der MS-Zufuhrleitung (2.11) des kapazitiven Spannungsteilers (2.5) der MS-Schalteinrichtung (2) vorhanden ist.

9. Verfahren gemäß Anspruch 6, **gekennzeichnet durch** die Tatsache, dass die Fernmess- und -steuervorrichtung (1) die Störung von zwei unterbrochenen Leitungen innerhalb einer elektrischen MS-Leitung anzeigt, wenn alle NS-Effektivwerte der Ausgleichsspannung U₂ >0,7 . U₂ sind und zur gleichen Zeit der Trennschalter (2.1) an ist und die Spannung in der MS-Zufuhrleitung (2.11) des kapazitiven Spannungsteilers (2.5) der MS-Schalteinrichtung (2) vorhanden ist.

10. Verfahren gemäß Anspruch 6, **gekennzeichnet durch** die Tatsache, dass die Fernmess- und -steuervorrichtung (1) die Störung von drei unterbrochenen Leitungen innerhalb einer elektrischen MS-Leitung anzeigt, wenn alle NS-Effektivwerte der Ausgleichsspannung U₂ >0,7 . U₂ sind und wenn zur gleichen Zeit der Trennschalter (2.1) an ist und die Spannung in der MS-Zufuhrleitung (2.11) des kapazitiven Spannungsteilers (2.5) der MS-Schalteinrichtung (2) abwesend ist.

11. Verfahren gemäß Anspruch 6, **gekennzeichnet durch** die Tatsache, dass die Fernmess- und -steuervorrichtung (1) die Störung der Transformatorstation anzeigt, wenn alle NS-Effektivwerte der Ausgleichsspannung U₂ >0,7 . U₂ sind und wenn zur gleichen Zeit die Spannung in der MS-Zufuhrleitung (2.11) des kapazitiven Spannungsteilers (2.5) der MS-Schalteinrichtung (2) vorhanden ist und der Trennschalter (2.1) aus ist.

## Revendications

1. Dispositif de commande et de mesure à distance (1) permettant une commande d'opération à distance d'une station de transformation moyenne-basse tension avec une ligne d'énergie électrique moyenne tension correspondante (2.9) et permettant une signalisation à distance de défauts dans celles-ci, la station de transformation moyenne-basse tension ayant un appareillage de commutation moyenne tension (2), une unité de transformateur moyenne-basse tension (3) et un dispositif de commutation basse tension (4), **caractérisé en ce que** le dispositif de commande et de mesure à distance (1) est adapté pour être intégré dans la station de transformation correspondante ou surveillée, et **en ce que** le dispositif de commande et de mesure à distance (1) est composé d'au moins un instrument de mesure (1.1) qui est connecté, via une ligne de communication (8), à au moins un dispositif de communication (1.3), et d'au moins un redresseur (1.2) ayant une batterie intégrée, le redresseur (1.2) étant connecté, via une ligne 7, à l'instrument de mesure (1.1) et au dispositif de communication (1.3) ; le dispositif de commande et de mesure à distance (1) étant connectable, via l'instrument de mesure (1.1), au dispositif de commutation basse tension (4) de sorte qu'il soit connectable, via une ligne (9) et par le biais d'un fusible basse tension (4.4), à une ligne d'alimentation basse tension triphasée (4.9) du dispositif de commutation basse tension (4) et, via une ligne (10), à un transformateur d'instrument basse tension (4.1) du dispositif de commutation basse tension (4),
en présence d'un premier signal d'état (D2), l'instrument de mesure (1.1) étant connectable, via une première ligne numérique (5), à un contact (2.2) d'un commutateur de séparation (2.1) de l'appareillage de commutation moyenne tension (2), et étant connectable, au moyen dudit contact (2.2), à l'unité de transformateur moyenne-basse tension (3), et
en présence d'un deuxième signal d'état (D1), l'instrument de mesure (1.1) étant connectable, via une deuxième ligne numérique (6), à un indicateur (2.6) afin d'indiquer une présence ou une absence de tension dans une ligne d'alimentation moyenne tension d'un diviseur de tension capacitif (2.5) de l'appareillage de commutation moyenne tension (2),
l'instrument de mesure (1.1) possédant un microprocesseur (30) et le dispositif de communication (1.3) comprenant des moyens destinés à identifier, sur la base d'une combinaison de données de l'instrument de mesure correspondant (1.1) et en présence du premier signal d'état (D2) et/ou du deuxième signal d'état (D1), le type et l'emplacement d'un défaut afin de générer une information et afin d'envoyer immédiatement, dès qu'il détecte le défaut, l'information au centre compétent et, si nécessaire, à d'autres adresses dans un délai fixé, le type et l'emplacement du défaut étant identifiables et le défaut étant détectable sur la base de changements de valeurs efficaces basse tension de tensions interphasesU₂ et d'un angle de temps α entre fonctions harmoniques fondamentales de tensions de phase,
le type et l'emplacement du défaut étant identifiables et le défaut étant détectable par ailleurs sur la base de la position marche/arrêt du commutateur de séparation (2.1) de l'appareillage de commutation moyenne tension (2),
et le type et l'emplacement du défaut étant identifiables et le défaut étant détectable par ailleurs sur la base de la présence ou l'absence de tension dans une ligne d'alimentation moyenne tension (2.11) du diviseur de tension capacitif (2.5) de l'appareillage de commutation moyenne tension (2).

2. Dispositif selon la revendication 1, **caractérisé en ce que** le nombre d'instruments de mesure (1.1) est sélectionné en fonction du nombre d'unités de transformateur moyenne-basse tension (3) dans la station de transformation.

3. Station de transformation moyenne-basse tension ayant un appareillage de commutation moyenne tension (2), une unité de transformateur moyenne-basse tension (3) et un dispositif de commutation basse tension (4), **caractérisée en ce qu'**elle comprend en outre au moins un dispositif de commande et de mesure à distance (1) selon l'une des revendications 1 ou 2, le dispositif de commande et de mesure à distance (1) étant connecté au dispositif de commutation basse tension (4) de sorte que le dispositif de commande et de mesure à distance (1) soit connecté, via la ligne (9) et par le biais d'un fusible basse tension (4.4), à une ligne d'alimentation basse tension triphasée (4.9) du dispositif de commutation basse tension (4) et, via la ligne (10), à un transformateur d'instrument basse tension (4.1) du dispositif de commutation basse tension (4).

4. Station de transformation moyenne-basse tension selon la revendication 3, **caractérisée en ce que** l'appareillage de commutation moyenne tension (2) est équipé d'un contact (2.2) servant à indiquer la position marche/arrêt d'un commutateur de séparation (2.1) dudit appareillage.

5. Station de transformation moyenne-basse tension selon la revendication 3 ou 4, **caractérisée en ce que** l'appareillage de commutation moyenne tension (2) est équipé d'un indicateur (2.6) servant à indiquer la présence ou l'absence d'une tension dans une ligne d'alimentation moyenne tension d'un diviseur de tension capacitif (2.5) dudit appareillage.

6. Procédé destiné à la commande d'opération à distance d'une station de transformation moyenne-basse tension avec une ligne d'énergie électrique moyenne tension correspondante (2.9) et destiné à la signalisation à distance de défauts dans celles-ci, **caractérisé en ce qu'**il utilise un dispositif de commande et de mesure à distance (1) selon la revendication 1 et le dispositif de communication (1.3), sur la base de combinaison de données de l'instrument de mesure correspondant (1.1) et en présence du premier signal d'état (D2) et/ou du deuxième signal d'état (D1), identifie le type et l'emplacement d'un défaut, génère une information, et dès qu'il détecte les défauts, envoie immédiatement l'information au centre compétent, et, si nécessaire, à d'autres adresses dans un délai fixé, selon lequel le type et l'emplacement du défaut sont identifiés et le défaut est détecté sur la base de changements de valeurs efficaces basse tension de tensions interphases U₂ et de l'angle de temps α entre fonctions harmoniques fondamentales de tensions de phase, selon lequel le type et l'emplacement du défaut sont identifiés et le défaut est détecté par ailleurs sur la base de la position marche/arrêt du commutateur de séparation (2.1) de l'appareillage de commutation moyenne tension (2), et selon lequel le type et l'emplacement du défaut sont identifiés et le défaut est détecté par ailleurs sur la base de la présence ou de l'absence de tension dans la ligne d'alimentation moyenne tension (2.11) du diviseur de tension capacitif (2.5) de l'appareillage de commutation moyenne tension (2).

7. Procédé selon la revendication 6, **caractérisé en ce qu'**un défaut de rupture d'un conducteur dans une ligne électrique moyenne tension est signalé si toutes les valeurs efficaces basse tension de tensions interphases sont U₂ > 0,7 . U_{2N} et si l'angle temporel est α < 15°, et si, en même temps, le commutateur de séparation (2.1) est sur la position marche et la tension dans la ligne d'alimentation moyenne tension (2.11) du diviseur de tension capacitif (2.5) de l'appareillage de commutation moyenne tension (2) est également présente.

8. Procédé selon la revendication 6, **caractérisé par le fait qu'**un défaut de rupture d'un conducteur dans la ligne électrique moyenne tension est signalé si une valeur efficace basse tension de tensions interphases est U₂ < 0,7 . U_{2N}, et si, en même temps, le commutateur de séparation (2.1) est sur la position marche et la tension dans la ligne d'alimentation moyenne tension (2.11) du diviseur de tension capacitif (2.5) de l'appareillage de commutation moyenne tension (2) est également présente.

9. Procédé selon la revendication 6, **caractérisé par le fait que** le dispositif de commande et de mesure à distance (1) signale le défaut de rupture de deux conducteurs dans la ligne électrique moyenne tension si toutes les valeurs efficaces basse tension de tensions interphases sont U₂ < 0,7 . U_{2N}, et si, en même temps, le commutateur de séparation (2.1) est sur la position marche et la tension dans la ligne d'alimentation moyenne tension (2.11) du diviseur de tension capacitif (2.5) de l'appareillage de commutation moyenne tension (2) est présente.

10. Procédé selon la revendication 6, **caractérisé par le fait que** le dispositif de commande et de mesure à distance (1) signale le défaut de rupture de trois conducteurs dans la ligne électrique moyenne tension si toutes les valeurs efficaces basse tension de tensions interphases sont U₂ < 0,7 . U_{2N}, et si, en même temps, le commutateur de séparation (2.1) est sur la position marche et la tension dans la ligne d'alimentation moyenne tension (2.11) du diviseur de tension capacitif (2.5) de l'appareillage de commutation moyenne tension (2) est absente.

11. Procédé selon la revendication 6, **caractérisé par le fait que** le dispositif de commande et de mesure à distance (1) signale le défaut de la station de transformation si toutes les valeurs efficaces basse tension de tensions interphases sont U₂ < 0,7 . U_{2N}, et si, en même temps, la tension dans la ligne d'alimentation moyenne tension (2.11) du diviseur de tension capacitif (2.5) de l'appareillage de commutation moyenne tension (2) est présente et le commutateur de séparation (2.1) est sur la position arrêt.
